(19) **Europäisches Patentamt**
**European Patent Office**
**Office européen des brevets**

(11) **EP 2 784 940 B1**

(12) **EUROPEAN PATENT SPECIFICATION**

(45) Date of publication and mention
of the grant of the patent:
**18.03.2015  Bulletin 2015/12**

(51) Int Cl.:
***H03L 7/099*** *(2006.01)*

(21) Application number: **13305382.7**

(22) Date of filing: **28.03.2013**

(54) **Voltage-controlled oscillator module and phase-locked loop device including the same**

Spannungsgesteuertes Oszillatormodul und Phasenregelkreisvorrichtung damit

Module d'oscillateur commandé en tension et boucle à phase asservie comprenant le même dispositif

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**01.10.2014  Bulletin 2014/40**

(73) Proprietor: **Asahi Kasei Microdevices Corporation
Tokyo 101-8101 (JP)**

(72) Inventors:
• **Canard, David
  14460 Colombelles (FR)**

• **Lecuyer, Matthieu
  14460 Colombelles (FR)**

(74) Representative: **Cabinet Plasseraud
52, rue de la Victoire
75440 Paris Cedex 09 (FR)**

(56) References cited:
**US-A1- 2006 038 620     US-A1- 2012 074 998
US-B1- 6 826 246**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The invention relates to a voltage-controlled oscillator (VCO) module and a phase-locked loop (PLL) device which includes such VCO module.

**-- BACKGROUND OF THE INVENTION --**

A major feature of a voltage-controlled oscillator is its gain value defined as the derivative of the frequency of the VCO signal which is outputted by the oscillator, with respect to an input direct voltage. This derivative is commonly called VCO gain and denoted $K_{VCO}$.

However, the frequency of the VCO signal may drift due to several causes, and a temperature variation of the VCO circuit is often a main one of these causes. Then, suitable tuning of the input direct voltage allows compensating for the frequency drift, so that the VCO signal appears to be constant in frequency.

In frequency synthesizers which are based on phase-locked loops including VCO circuits, low $K_{VCO}$ values are preferred in particular for the following reasons:

-    possible noise on the frequency tuning voltage leads to less noise in the phase of the VCO signal when the Kvco value is low;

-    the charge-pump current of the phase-locked loop can be larger, thus reducing the phase noise within the phase-locked loop; and

-    low $K_{VCO}$ value makes easier the integration of a loop filter within the phase-locked loop.

But a low $K_{VCO}$ value may be insufficient for enabling compensation for large frequency drifts, as such large drifts may be caused by temperature variations.

Solutions have been already implemented for combining using a low $K_{VCO}$ value together with enabling compensation for possible large frequency drifts. First ones of these known solutions implement each a VCO module which comprises:

-    a VCO circuit which is adapted for outputting the VCO signal, and provided with first and second voltage inputs both designed for tuning the frequency of the VCO signal; and

-    a compensation circuit which has an output connected to the second voltage input of the VCO circuit.

The first voltage input of the VCO circuit is the usual one, which may correspond to a small value for the VCO gain when required. In particular, this first voltage input may participate in a feedback loop of a frequency synthesizer based on a phase-locked loop. The second voltage input of the VCO circuit is dedicated to compensating for the large frequency drifts. The compensation circuit comprises parameter sensors, including a temperature sensor, and components which are selected for matching frequency drifts of the VCO circuit which are due to deviations of the parameters. The compensation circuit thus analog-tunes continuously the voltage which is transmitted at the second input of the VCO circuit so as to compensate for the frequency drifts. But such compensation is difficult and expensive to implement. In particular, it requires a precise knowledge of all parameters which may cause frequency drift, and the maximum possible deviation of each of these parameters.

In other known solutions, the VCO circuit is provided with a digitally controlled capacitor bank, and the VCO module also comprises a temperature sensor and a re-calibration unit which is suitable for digitally controlling the capacitance value of the capacitor bank. The re-calibration unit updates the capacitance value when the deviation between the currently sensed temperature and a prior temperature used for the previous updating becomes above a threshold. But such operation generates significant disturbance of the VCO signal at each updating event, and is not compatible with continuous delivery of the VCO signal.

Therefore, one object of the present invention is to propose a novel VCO module which is provided with compensation for frequency drift, but without the drawbacks of the existing solutions. In particular, the invention aims at combining using a low $K_{VCO}$ value together with enabling compensation for large drifts of the VCO signal frequency, in a low-cost and efficient manner.

The patent application publication US 2012/074998 A1 discloses a transconductance integrator which produce an integrator output voltage for compensating the frequency drift of the VCO and thereby maintaining the voltage at the first VCO control input at a constant value.

**-- SUMMARY OF THE INVENTION --**

For meeting this object or others, a first aspect of the invention proposes a VCO module which comprises a VCO circuit with first and second inputs for receiving respective frequency tuning voltages, and also a compensation circuit connected to the second voltage input of the VCO circuit. In the VCO module of the invention, the compensation circuit comprises itself an integrator which has an input connected to the first voltage input of the VCO circuit, and an output connected to the output of the compensation circuit. The integrator is adapted for producing at the integrator output a voltage based on integration over time, of effective values which are obtained from values of a voltage transmitted at the input of the integrator.

Hence, in a VCO module according to the invention, the compensation circuit continually analog-tunes the voltage which is applied onto the second input of the VCO circuit, so that the operation of the VCO circuit is not interrupted. The VCO signal can thus be continually delivered. This tuning performed by the compensation circuit can compensate for large frequency drifts, while the first voltage input of the VCO circuit is used for operation with low $K_{VCO}$ value. Actually, the drift compensation which is performed by using the second voltage input of the VCO circuit takes over from that produced by using the first voltage input when the frequency drift is too large with respect to the Kvco value. In this way, any frequency drift can be compensated for and small ones keep compensated by implementing an effective low $K_{VCO}$ value.

According to one special feature of the invention, the integrator is adapted so that each effective value is obtained as a function of the value of the voltage transmitted at the input of this integrator, and this function has a reduced slope within a linear operation range for the value of the voltage transmitted at the input of the integrator. The linear operation range is finite in length on both low value side and high value side. In addition, the function slope is steeper out of the linear operation range when compared to within the linear operation range, and is devoid of any change in the slope sign.

Furthermore, the function for determining the effective value equals zero for at least one value of the voltage which is transmitted at the input of the integrator, within the linear operation range. In this way, frequency drift compensation using the second voltage input of the VCO circuit and usual control of the frequency with low $K_{VCO}$ value can be performed at the same time while being functionally almost separated.

Preferably, the slope of the effective value as function of the value of the voltage which is transmitted at the first integrator input may have at least one value out of the linear operation range higher than within this linear operation range, by a factor greater than two, more preferably five or ten.

Preferably also, the integrator may be designed so that the function which determines the effective value equals zero over the whole linear operation range. Thus, no frequency drift compensation using the second voltage input is effective as long as the voltage at the first voltage input of the VCO circuit has not exceeded the limits of the linear operation range.

Optionally, the integrator may be provided with two reference voltage inputs, which are suitable for tuning two limits of the linear operation range.

In some simple implementations of the invention, the integrator may be comprised of a transconductor and a capacitor connected in series, and a node intermediate between the transconductor and the capacitor. Then, this node is connected to the output of the integrator. In such implementations, a voltage input of the transconductor forms the input of the integrator, and values of a current which is outputted by the transconductor into the capacitor form the effective values.

Preferably again, a VCO-gain of the VCO circuit which relates to the first voltage input may be less than another VCO-gain of the VCO circuit related to the second voltage input, each VCO-gain being a derivative of the frequency of the VCO signal with respect to the value of the voltage transmitted at the corresponding first or second voltage input, while the value transmitted at the other one of the first and second voltage inputs is kept constant.

A second aspect of the invention also proposes a phase-locked loop device which comprises:

- a VCO module in accordance with the first invention aspect as just described;

- a phase comparison system which is connected for receiving a reference clock phase and a phase derived from the VCO signal outputted by the VCO module, and this phase comparison system being adapted for producing a comparison signal representative of a difference between the reference clock phase and the phase derived from the VCO signal;

- a loop filter which is connected in series and downstream with the phase comparison system so as to receive at input the comparison signal, and adapted to produce at output a voltage corresponding to the comparison signal filtered; and

- a frequency converter which is adapted for producing the phase derived from the VCO signal by frequency division or frequency elevation with fixed division or elevation factor.

In the PLL device of the invention, an output of the loop filter is connected to the first voltage input of the VCO circuit, so that the VCO circuit from this first voltage input, the frequency converter, the phase comparison system and the loop filter pertain to a first feedback loop within the PLL device, and also the integrator, the VCO circuit from its second voltage input, the frequency converter, the phase comparison system and the loop filter additionally pertain to a second feedback loop within the PLL device.

These and other features of the invention will be now described with reference to the appended figures, which relate to preferred but not-limiting embodiments of the invention.

## -- BRIEF DESCRIPTION OF THE DRAWINGS --

Figure 1 is a block diagram of a VCO module according to the invention;

Figure 2 is an electric diagram of a VCO circuit possibly used for embodying the invention;

Figure 3a is block diagram of a VCO module according to a particular embodiment of the invention, and Figure 3b is a chart relating to a transconductor used in the embodiment of Figure 3a;

Figure 4 is an electric diagram of a transconductor suitable for obtaining the chart of Figure 3b; and

Figure 5a is a block diagram of a PLL device according to the invention, and Figure 5b is a corresponding frequency analysis diagram.

Same reference numbers which are indicated in different ones of these figures denote identical elements of elements with identical function. In addition, components with well-known function and operation but not connected directly to the invention features are not described in detail.

## -- DETAILED DESCRIPTION OF THE INVENTION --

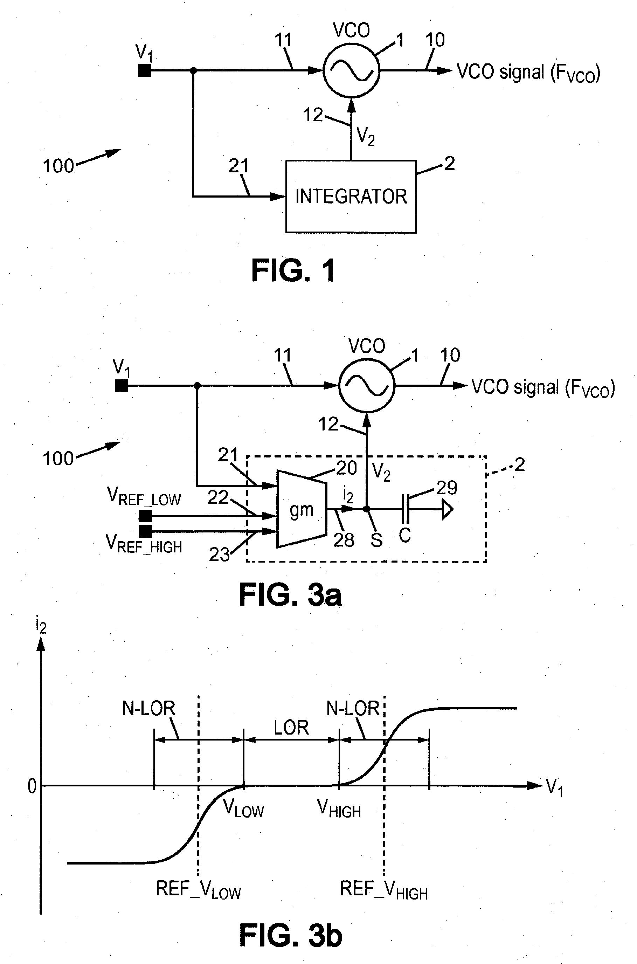

With reference to Figure 1, the VCO module 100 comprises a VCO circuit 1 and an integrator 2.

The VCO circuit 1 is provided with an output 10 for delivering the VCO signal, and two voltage inputs 11 and 12. Both inputs 11 and 12 are arranged for receiving respective direct voltages $V_1$ and $V_2$, so that the frequency $F_{VCO}$ of the VCO signal varies as a function of both $V_1$- and $V_2$-values. Preferably, for one operation mode of the VCO module 100, the $V_1$-derivative of the frequency $F_{VCO}$ while $V_2$-value is kept constant, may be greater than the $V_2$-derivative of the frequency $F_{VCO}$ with constant $V_1$-value. Put another way, the frequency of the VCO signal which is delivered by the VCO circuit 1 may depend more steeply on $V_1$-variations than $V_2$-variations, at least in a linear operation range. This may also be the opposite out of the linear operation range.

According to one feature of the invention, the $V_2$-voltage which is transmitted at the input 12 of the VCO circuit 1, is produced from the $V_1$-voltage which is transmitted at the input 11 using the integrator 2. Thus, an input 21 of the integrator 2 is connected to the voltage input 11 of the VCO circuit 1, so that the integrator 2 is fed at input with the $V_1$-voltage at the same time as the VCO circuit 1. The integrator 2 is also connected at output to the voltage input 12 of the VCO circuit 1. Hence, the integrator 2 produces the $V_2$-voltage from the $V_1$-voltage, and the $V_2$-voltage so-produced is also fed into the VCO circuit 1.

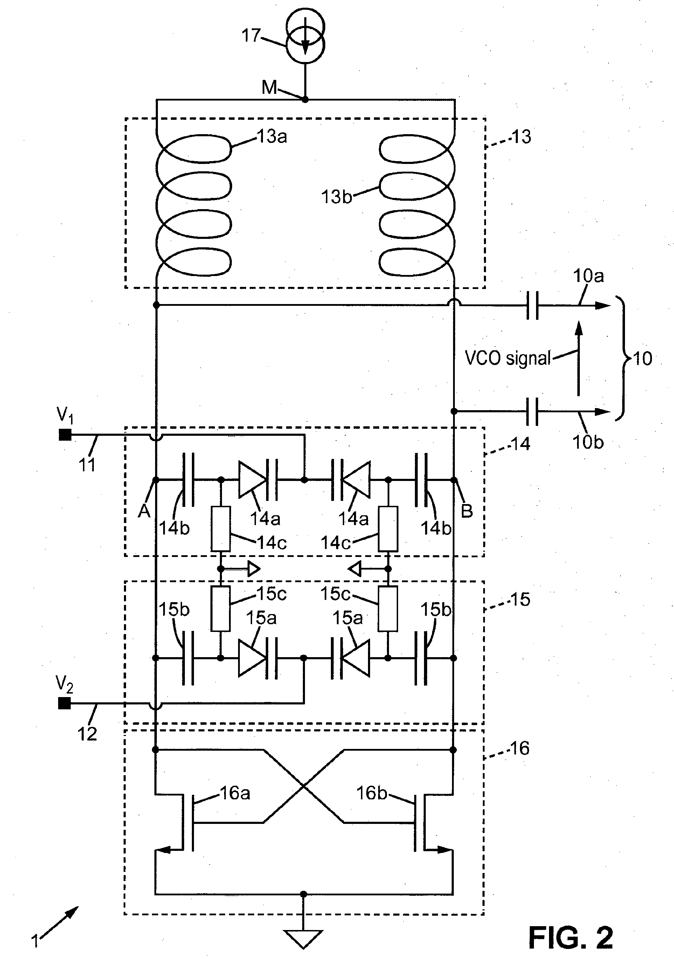

Figure 2 shows a possible structure for the VCO circuit 1. Such structure is well-known so that a short description is sufficient for the Man skilled in the art to understand its operation. The VCO circuit 1 is comprised of an inductor block 13, two capacitors blocks 14 and 15, and a negative resistance block 16 which are connected in parallel with each other between nodes A and B. The whole structure is energy-fed by a direct current source 17, and may have a symmetric composition for improving common mode rejection. Thus, the inductor block 13 may be comprised of two coils 13a and 13b connected in series, with the mid-point M connected to the output of the current source 17. Negative resistance block 16 may be comprised of two N-transistors 16a and 16b with the gate of each one connected to the collector of the other one, and the emitters of both transistors 16a and 16b connected to a common reference node represented by a triangle. The negative resistance block 16 compensates for energy losses occurring elsewhere in the VCO circuit 1, in particular in the inductor block 13 and the capacitor blocks 14 and 15.

The capacitor block 14 may be comprised of two branch segments which connect the voltage input 11 respectively to the nodes A and B. Reference 14a denotes varactors which may be based in a usual manner on diode or FET-transistor components. Varactors 14a or each branch segment are preferably identical, and both capacitors 14b are also preferably equal to each other. Each branch segment is also provided with a polarization resistance 14c. Due to the varactor operation, the overall capacitance value of the capacitor block 14 changes upon varying the value of the direct voltage $V_1$.

Capacitor block 15 may have a structure similar to that of capacitor block 14, with reference numbers 15a-15c having respective meanings similar to 14a-14c previously introduced. Preferably, the varactors 14a and 15a may be designed so that the capacitance value of the varactors 15a is a function of the $V_2$-voltage, which is steeper than that of the capacitance value of the varactors 14a depending on the $V_1$-voltage. For consistency, the capacitance value of the capacitors 15b may also be higher than that of the capacitors 14b.

The VCO signal which is outputted by the VCO circuit 1 is the AC-voltage existing between both nodes A and B. Thus, the ouput 10 for the VCO signal is of differential type. The capacitors which are arranged on both lines 10a and 10b of the differential output 10 prevent that direct current originating from the current source 17 flows away through the output 10, but they preferably have no function with respect to the VCO signal.

Referring now to Figure 3a, the integrator 2 may be comprised of a transconductor 20 connected in series with a capacitor 29. gm denotes the differential transconductance value of the transconductor 20, and C is the capacitance value of the capacitor 29. The transconductor 20 operates as an entrance stage of the integrator 2, thus transforming the $V_1$-voltage which is received at the input 21 into a current $i_2$ which is delivered at the transconductor output 28 and fed into the capacitor 29. The voltage input 12 of the VCO circuit 1 is then connected to a node S intermediate between the output 28 of the transconductor 20 and the capacitor 29.

The transconductor 20 may have a non-linear chart as represented in Figure 3b. This chart shows the variations of the current $i_2$ as a function of the input voltage $V_1$. These variations are linear with small slope gm within a middle range of this chart located between two side ranges where the slope is deeper. The middle range where the slope is reduced has been called linear operation range in the general description of the invention, and is currently denoted LOR. The side ranges where the slope is deeper are denoted N-LOR for non-linear operation ranges. Two reference voltages denoted $V_{REF\_LOW}$ and $V_{REF\_HIGH}$ indicate respective center positions for the N-LOR ranges along the $V_1$-axis. For example, the $V_1$-derivative of the $i_2$-current for some of the $V_1$-values in the N-LOR ranges may be greater than within the LOR range by a factor of more than two, or better more than five or ten. The reference voltages $V_{REF\_LOW}$ and $V_{REF\_HIGH}$ may be set using suitable additional inputs 22 and 23 provided to the transconductor 20 (see Figure 3a). Thus, changing the reference voltages $V_{REF\_LOW}$ and $V_{REF\_HIGH}$ allows tuning the limits $V_{LOW}$ and $V_{HIGH}$ of the linear operation range. The slope gm of the variations of the current $i_2$ as a function of the voltage $V_1$ is constant in sign over the whole LOR and N-LOR ranges, but possibly reaching zero-slope. In addition, due to saturation effects, the current $i_2$ is obviously limited in value on both external sides of the non-linear operation ranges, i.e. for $V_1$-values much less than $V_{REF\_LOW}$ or much larger than $V_{REF\_HIGH}$.

The current $i_2$ is zero for at least one $V_1$-value in the LOR range, which is preferably the center $V_1$-value of this range.

In preferred embodiments of the invention, the current $i_2$ may be zero over the whole LOR range, so that variations of the $V_1$-voltage within the LOR range have no effect on the $V_2$-voltage. Thus no alteration of the frequency $F_{VCO}$ of the VCO signal is caused through the voltage input 12 of the VCO circuit 1. But the $V_1$-voltage is still effective for tuning the frequency $F_{VCO}$ of the VCO signal due to the voltage input 11 of the VCO circuit 1.

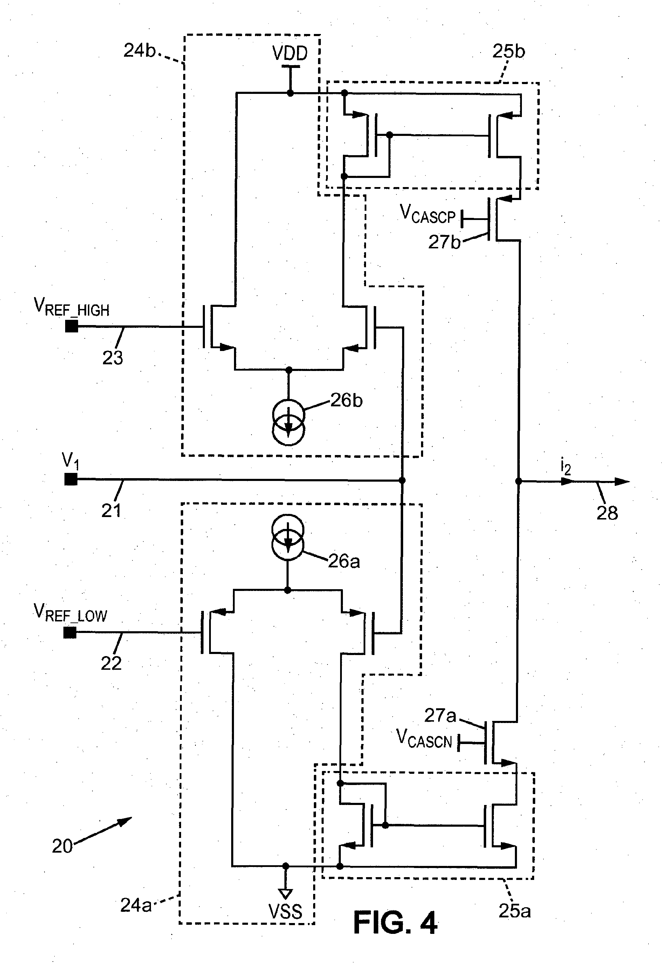

Figure 4 shows a possible structure for the transconductor 20. It may comprise:

- a P-transistor differential pair 24a, with a first gate input which is connected to the transconductor input 21, and a second gate input which is intended for receiving the lower reference voltage $V_{REF\_LOW}$;

- a first current-mirror assembly 25a, which is connected for extracting from the transconductor ouput 28 a current which reproduces a first internal current flowing in the branch of the P-transistor differential pair 24a related to the first gate input;

- a N-transistor differential pair 24b, with another first gate input which is also connected to the transconductor input 21, and another second gate input which is intended for receiving the upper reference voltage $V_{REF\_HIGH}$; and

- a second current-mirror assembly 25b, which is connected for supplying the transconductor ouput 28 with a current which reproduces a second internal current flowing in the branch of the N-transistor differential pair 24b related to the first gate input of this latter N-transistor differential pair.

The second gate inputs of the transistor differential pairs 24a and 24b thus form the additional inputs 22 and 23, respectively. References 26a and 26b denote current sources arranged for current-supplying the transistor differential pairs 24a and 24b. VDD and VSS respectively denote upper and lower voltage supply sources. Optionally, transistors 27a and 27b may be used with cascode arrangement for increasing the output parallel-impedance of the transconductor 20. Then $V_{CASCN}$ and $V_{CASCP}$ denote polarization voltage supply sources used for setting the respective gate voltages of the transistors 27a and 27b.

When the $V_1$-voltage value is between the reference voltage values $V_{REF\_LOW}$ and $V_{REF\_HIGH}$, or more precisely between the LOR range limits $V_{LOW}$ and $V_{HIGH}$, zero-current is extracting from or supplied to the transconductor ouput 28, so that the output current $i_2$ exhibits very low noise or nearly zero noise. Such low noise on $i_2$-current is even more reduced since no internal current is also flowing in the branches of the N- and P-transistor differential pairs 24a and 24b, which are related to the first gate inputs for operation within the LOR range.

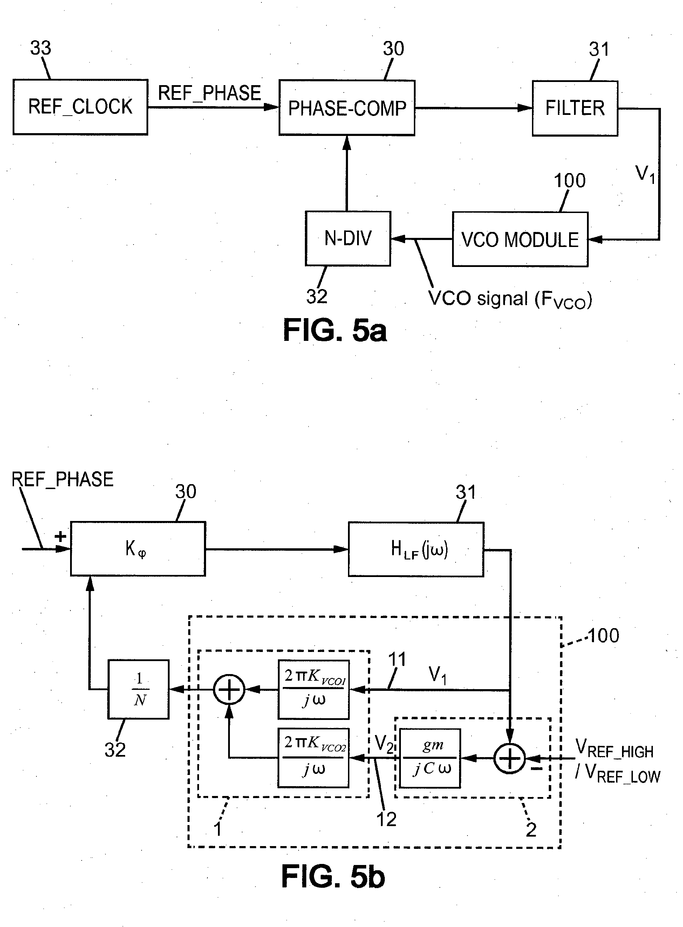

Figure 5a shows a phase-locked loop device incorporating the VCO module 100. The additional references in this figure have the following meanings:

30    phase comparison system denoted PHASE_COMP, with phase comparison gain $K_\varphi$;

31    loop filter denoted FILTER, with transfer function $H_{LF}(j\omega)$, where j is the complex number unit and $\omega$ is a Fourier component pulsation;

32    frequency converter, which may be a N-divider or N-multiplier, N being a division or multiplication factor greater than unity; and

33    reference clock denoted REF_CLOCK, which supplies a reference clock phase REF_PHASE.

In this PLL device, the frequency converter 32 decreases or increases the frequency of the VCO signal by the N-factor. The phase comparison system 30 produces a comparison signal which represents the difference between the reference clock phase and the phase of the signal delivered by the frequency converter 32. Then, the loop filter 31 operates a time-filtering onto the comparison signal for delivering the $V_1$-voltage. And this latter is fed into the VCO module 100.

Figure 5b corresponds to Figure 5a for showing the combination of the transfer functions of all the components of the PLL device. Functionally, this PLL device implements two feedback loops having shared components, with the following loop assignment:

-    for the first feedback loop: the VCO circuit 1 from its voltage input 11, the frequency converter 32, the phase comparison system 30, and the loop filter 31;
-    for the second feedback loop: the VCO circuit 1 from its voltage input 12, the frequency converter 32, the phase comparison system 30, the loop filter 31, and the integrator 2.

Within the second feedback loop, the integrator 2 continually adjusts the $V_2$-voltage so that the $V_1$-voltage remains within the LOR range of Figure 3b. Hence, no interruption is caused in the delivery of the VCO signal, while combining small value for the Vi-derivative of the frequency $F_{VCO}$ together with compensation for large frequency drifts.

As an example, a N-divider denoted N-DIV is used for the frequency converter 32, so that the whole PLL device is a frequency elevator.

Then, the open-loop transfer function of the PLL device is the following one, as a function of the complex parameter $j\omega$:

$$OL(j\omega) = \frac{2\pi \cdot K_\varphi \cdot H_{LF}(j\omega) \cdot K_{VCO1}}{N \cdot j\omega} \cdot \left[ 1 + \frac{gm \cdot K_{VCO2}}{jC\omega \cdot K_{VCO1}} \right]$$

where $K_{VCO\,1}$ is the $V_1$-derivative of the frequency $F_{VCO}$ of the VCO signal at constant $V_2$-voltage, and $K_{VCO\,2}$ is the $V_2$-derivative of the same frequency $F_{VCO}$ at constant $V_1$-voltage. As already mentioned, $K_{VCO\,1}$ is preferably smaller than $K_{VCO\,2}$.

Therefore, the condition for operation stability of the PLL device is: $\dfrac{gm \cdot K_{VCO2}}{C\omega \cdot K_{VCO1}} << 1$, namely the first member ratio much less than unity for a value of the pulsation $\omega$ yielding an open-loop gain equal to unity in the first feedback loop. Practically, the first member ratio may be less than 0.1 for such $\omega$-value.

It is reminded that the benefits of the invention include: no prior knowledge of the frequency drift causes is necessary, compensation is efficient for any cause of the frequency drift and not only temperature-caused drifts, no circuit matching is required, VCO signal is continually available even when large drift compensation is being performed, low value of the VCO-gain is effective, and low phase noise is generated. However, the invention embodiment which has been above-described in detail may be adapted with respect to some aspects while retaining at least some of these invention benefits. Additionally, the invention VCO module and PLL device may be embodied either in analog mode as described, or in digital mode. The Man skilled in the art will be able to derive any digital embodiment of the invention without involving inventiveness.

## Claims

1. Voltage-controlled oscillator (VCO) module (100) provided with compensation for frequency drift, said VCO module comprising:

   - a VCO circuit (1) adapted for outputting a VCO signal, and provided with first (11) and second (12) voltage inputs both designed for tuning one same frequency ($F_{VCO}$) of the VCO signal; and
   - a compensation circuit having an output connected to the second voltage input (12) of the VCO circuit (1),

   the compensation circuit comprises an integrator (2) having an input (21) connected to the first voltage input (11) of the VCO circuit (1), and an output connected to the output of the compensation circuit, said integrator being adapted for producing at the integrator output a voltage ($V_2$) based on an integration over time, of effective values obtained as a function of values of a voltage ($V_1$) transmitted at the input of the integrator, **characterized in that** said function has reduced slope within a linear operation range (LOR) for said value of the voltage transmitted at the input of the integrator, said linear operation range being finite in length on both low value side and high value side, and the function slope being steeper out of the linear operation range when compared to within said linear operation range, and being devoid of any change in slope sign, and said function equalling zero for at least one value of the voltage ($V_1$) transmitted at the input (21) of the integrator (2), within the linear operation range (LOR).

2. VCO module (100) according to Claim 1, wherein the integrator (2) is designed so that the function which determines the effective values equals zero over the linear operation range.

3. VCO module (100) according to Claim 1 or 2, wherein the integrator (2) is provided with two reference voltage inputs (22, 23), suitable for tuning two limits of the linear operation range (LOR).

4. VCO module (100) according to any one of the preceding claims, wherein the integrator (2) is comprised of a transconductor (20) and a capacitor (29) connected in series, and a node (S) intermediate between said transconductor and said capacitor, said node being connected to the output of the integrator, a voltage input of the transconductor forming the input (21) of the integrator, and values of a current ($i_2$) outputted by the transconductor into the capacitor forming the effective values.

5. VCO module (100) according to Claim 4, wherein the transconductor (20) comprises;

   - a P-transistor differential pair (24a) with first gate input connected to the voltage transconductor input, and second gate input intended for receiving a lower reference voltage ($V_{REF\_LOW}$) setting a lower limit ($V_{LOW}$) of the linear operation range (LOR);
   - a first current-mirror assembly (25a) connected for extracting from the transconductor ouput (28) a current which reproduces a first internal current flowing in a branch of the P-transistor differential pair (24a) related to the first gate input of said P-transistor differential pair;
   - a N-transistor differential pair (24b) with another first gate input also connected to the voltage transconductor input, and another second gate input intended for receiving an upper reference voltage ($V_{REF\_HIGH}$) setting an upper limit ($V_{HIGH}$) of the linear operation range (LOR); and
   - a second current-mirror assembly (25b) connected for supplying the transconductor ouput (28) with a current which reproduces a second internal current flowing in a branch of the N-transistor differential pair (24b) related to said another first gate input of the N-transistor differential pair.

6. VCO module (100) according to any one of the preceding claims, wherein a VCO-gain ($K_{VCO\,1}$) of the VCO circuit (1) related to the first voltage input (11) is less than another VCO-gain ($K_{VCO\,2}$) of said VCO circuit related to the second voltage input (12), each VCO-gain being a derivative of the frequency ($F_{VCO}$) of the VCO signal with respect to the value of the voltage ($V_1$, V2) transmitted at the corresponding first or second voltage input, while the value transmitted at the other one of said first and second voltage inputs is being kept constant.

7.  Phase-locked loop (PLL) device comprising:

    - a VCO module (100) in accordance with any one of the preceding claims;
    - a phase comparison system (30) connected for receiving a reference clock phase (REF_PHASE) and a phase derived from the VCO signal outputted by the VCO module (100), and said phase comparison system being adapted for producing a comparison signal representative of a difference between the reference clock phase and the phase derived from the VCO signal;
    - a loop filter (31) connected in series and downstream with the phase comparison system (30) so as to receive at input the comparison signal, and adapted to produce at output a voltage corresponding to the comparison signal filtered; and
    - a frequency converter (32) adapted for producing the phase derived from the VCO signal by frequency division or frequency elevation with fixed division or elevation factor;

    wherein an output of the loop filter (31) is connected to the first voltage input (11) of the VCO circuit (1), so that the VCO circuit from the first voltage input (11), the frequency converter (32), the phase comparison system (30) and the loop filter (31) pertain to a first feedback loop within the PLL device, and also the integrator (2), the VCO circuit from the second voltage input (12), the frequency converter (32), the phase comparison system and the loop filter additionally pertain to a second feedback loop within said PLL device.

**Patentansprüche**

1.  Spannungsgesteuertes Oszillator (VCO)-Modul (100), das mit Kompensation für Phasenverschiebung versehen ist, wobei das VCO-Modul umfasst:

    - eine VCO-Schaltung (1), die zum Ausgeben eines VCO-Signals ausgelegt und mit ersten (11) und zweiten (12) Spannungseingängen versehen ist, die beide zum Abstimmen einer gleichen Frequenz ($F_{VCO}$) des VCO-Signals konzipiert sind; und
    - eine Kompensationsschaltung mit einem Ausgang, der mit dem zweiten Spannungseingang (12) der VCO-Schaltung (1) verbunden ist,

    wobei die Kompensationsschaltung einen Integrator (2) mit einem Eingang (21), der mit dem ersten Spannungseingang (11) der VCO-Schaltung (1) verbunden ist, und einem Ausgang umfasst, der mit dem Ausgang der Kompensationsschaltung verbunden ist, wobei der Integrator so ausgelegt ist, dass er am Integratorausgang basierend auf einer Integration im Zeitablauf eine Spannung ($V_2$) von Effektivwerten erzeugt, die als eine Funktion von Werten einer Spannung ($V_1$) erhalten werden, die am Eingang des Integrators übertragen werden, **dadurch gekennzeichnet, dass** die Funktion eine reduzierte Steigung innerhalb eines linearen Arbeitsbereichs (LOR) für den Wert der Spannung aufweist, der am Eingang des Integrators übertragen wird, wobei der lineare Arbeitsbereich sowohl auf der niederwertigen Seite als auch auf der hochwertigen Seite eine endliche Länge aufweist, und die Funktionssteigung außerhalb des linearen Arbeitsbereichs steiler als innerhalb des linearen Arbeitsbereichs und frei von jeglicher Änderung des Steigungsvorzeichens ist, und die Funktion für mindestens einen Wert der Spannung ($V_1$), der am Eingang (21) des Integrators (2) übertragen wird, innerhalb des linearen Arbeitsbereichs (LOR) null entspricht.

2.  VCO-Modul (100)nach Anspruch 1 oder 2, wobei der Integrator (2) so konzipiert ist, dass die Funktion, welche die Effektivwerte bestimmt, über den linearen Arbeitsbereich null entspricht.

3.  VCO-Modul (100) nach Anspruch 1 oder 2, wobei der Integrator (2) mit zwei Referenzspannungseingängen (22, 23) versehen ist, die zum Abstimmen von zwei Grenzen des linearen Arbeitsbereichs (LOR) geeignet sind.

4.  VCO-Modul (100) nach einem der vorhergehenden Ansprüche, wobei der Integrator (2) einen Transkonduktor (20) und einen Kondensator (29), die in Reihe geschaltet sind, und ein Knoten (S) zwischen dem Transkonduktor und dem Kondensator umfasst, wobei der Knoten mit dem Ausgang des Integrators verbunden ist, ein Spannungseingang des Transkonduktors den Eingang (21) des Integrators bildet und durch den Transkonduktor Werte eines Stroms ($i_2$) in den Kondensator ausgegeben werden, welche die Effektivwerte bilden.

5. VCO-Modul (100) nach Anspruch 4, wobei der Transkonduktor (20) umfasst:

- ein p-Transistor-Differenzpaar (24a) mit einem ersten Gateeingang, der mit dem Transkonduktor-Spannungseingang verbunden ist, und einem zweiten Gateeingang, der zum Empfangen einer unteren Referenzspannung ($V_{REF\_LOW}$) bestimmt ist, die eine untere Grenze ($V_{LOW}$) des linearen Arbeitsbereichs (LOR) festlegt;
- eine erste Stromspiegelanordnung (25a), die zum Entnehmen aus dem Transkonduktorausgang (28) eines Stroms angeschlossen ist, der einen ersten internen Strom reproduziert, der in einem Zweig des p-Transistor-Differenzpaares (24a) fließt, der mit dem ersten Gateeingang des p-Transistor-Differenzpaares in Beziehung steht;
- ein n-Transistor-Differenzpaar (24b) mit einem anderen ersten Gateeingang, der ebenfalls mit dem Transkonduktor-Spannungseingang verbunden ist, und einem anderen zweiten Gateeingang, der zum Empfangen einer oberen Referenzspannung ($V_{REF\_HIGH}$) bestimmt ist, die eine oberen Grenze ($V_{HIGH}$) des linearen Arbeitsbereichs (LOR) festlegt;
- eine zweite Stromspiegelanordnung (25b), die zum Versorgen des Transkonduktorausgangs (28) mit einem Strom angeschlossen ist, der einen zweiten internen Strom reproduziert, der in einem Zweig des n-Transistor-Differenzpaares (24b) fließt, der mit dem anderen ersten Gateeingang des n-Transistor-Differenzpaares in Beziehung steht.

6. VCO-Modul (100) nach einem der vorhergehenden Ansprüche, wobei eine VCO-Verstärkung ($K_{VCO\,1}$) der VCO-Schaltung (1), die mit dem ersten Spannungseingang (11) in Beziehung steht, niedriger als eine andere VCO-Verstärkung ($K_{VCO\,2}$) der VCO-Schaltung ist, die mit dem zweiten Spannungseingang (12) in Beziehung steht, wobei jede VCO-Verstärkung eine Ableitung der Frequenz ($F_{VCO}$) des VCO-Signals in Bezug auf den Wert der Spannung ($V_1$, $V_2$) ist, der am entsprechenden ersten und zweiten Spannungseingang übertragen wird, während der Wert, der am anderen der ersten und zweiten Spannungseingänge übertragen wird, konstant gehalten wird.

7. Phasenregelkreis (PLL)-Vorrichtung, umfassend:

- ein VCO-Modul (100) nach einem der vorhergehenden Ansprüche;
- ein Phasenvergleichssystem (30), das zum Empfangen einer Referenztaktphase (REF PHASE) und einer Phase angeschlossen ist, die vom VCO-Signal abgeleitet ist, das vom VCO-Signal (100) ausgegeben wird, (100), wobei das Phasenvergleichssystem so ausgelegt ist, dass es ein Vergleichssignal erzeugt, das eine Differenz zwischen der Referenztaktphase und der vom VCO-Signal abgeleiteten Phase darstellt;
- ein Schleifenfilter (31), das mit dem Phasenvergleichssystem (30) in Reihe geschaltet und diesem nachgelagert ist, um das Vergleichssignal am Eingang zu empfangen, und so ausgelegt ist, dass es am Ausgang eine Spannung erzeugt, die dem gefilterten Vergleichssignal entspricht; und
- einen Frequenzumsetzer (32), der so ausgelegt ist, dass er die vom VCO-Signal abgeleitete Phase durch Frequenzteilung oder Frequenzerhöhung mit festem Teilungs- oder Erhöhungsfaktor erzeugt;

wobei ein Ausgang des Schleifenfilters (31) mit dem ersten Spannungseingang (11) der VCO-Schaltung (1) verbunden ist, so dass die VCO-Schaltung vom ersten Spannungseingang (11), der Frequenzumsetzer (32), das Phasenvergleichssystem (30) und das Schleifenfilter (31) zu einer ersten Rückkopplungsschleife der PLL-Vorrichtung gehören, und außerdem der Integrator (2), die VCO-Schaltung vom zweiten Spannungseingang (12), der Frequenzumsetzer (32), das Phasenvergleichssystem und das Schleifenfilter zusätzlich zu einer zweiten Rückkopplungsschleife der PLL-Vorrichtung gehören.

## Revendications

1. Module d'oscillateur commandé en tension (VCO) (100) pourvu d'une compensation de dérive de fréquence, ledit module VCO comprenant :

- un circuit VCO (1) adapté pour émettre en sortie un signal VCO, et pourvu de première (11) et seconde (12) entrées de tension conçues toutes les deux pour régler une même fréquence ($F_{VCO}$) du signal VCO ; et
- un circuit de compensation ayant une sortie connectée à la seconde entrée de tension (12) du circuit VCO (1),

le circuit de compensation comprend un intégrateur (2) ayant une entrée (21) connectée à la première entrée de tension (11) du circuit VCO (1), et une sortie connectée à la sortie du circuit de compensation, ledit intégrateur étant adapté pour produire à la sortie de l'intégrateur une tension ($V_2$) basée sur une intégration dans le temps de valeurs effectives obtenues comme une fonction de valeurs d'une tension ($V_1$) transmise à l'entrée de l'intégrateur, **caractérisé en ce que** ladite fonction a une pente réduite dans une plage de fonctionnement linéaire (LOR) pour ladite valeur de la tension transmise à l'entrée de l'intégrateur, ladite plage de fonctionnement linéaire étant de longueur finie du côté des valeurs basses comme du côté des valeurs élevées, et la pente de la fonction étant plus accentuée à l'extérieur de la plage de fonctionnement linéaire que dans la plage de fonctionnement linéaire, et étant dépourvue de tout changement de signe de la pente, et

ladite fonction étant égale à zéro pour au moins une valeur de la tension ($V_1$) transmise à l'entrée (21) de l'intégrateur (2), dans la plage de fonctionnement linéaire (LOR).

2. Module VCO (100) selon la revendication 1, dans lequel l'intégrateur (2) est conçu de manière à ce que la fonction qui détermine les valeurs effectives soit égale à zéro sur la plage de fonctionnement linéaire.

3. Module VCO (100) selon la revendication 1 ou 2, dans lequel l'intégrateur (2) est pourvu de deux entrées de tension de référence (22, 23), permettant le réglage de deux limites de la plage de fonctionnement linéaire (LOR).

4. Module VCO (100) selon l'une quelconque des revendications précédentes, dans lequel l'intégrateur (2) est constitué d'un transconducteur (20) et d'un condensateur (29) connectés en série, et d'un noeud (S) intermédiaire entre ledit transconducteur et ledit condensateur, ledit noeud étant connecté à la sortie de l'intégrateur, une entrée de tension du transconducteur formant l'entrée (21) de l'intégrateur, et les valeurs d'un courant ($i_2$) transmis en sortie par le transconducteur à l'intégrateur formant les valeurs effectives.

5. Module VCO (100) selon la revendication 4, dans lequel le transconducteur (20) comprend :

- une paire différentielle de transistors P (24a) avec une première entrée de grille connectée à l'entrée de tension du transconducteur, et une seconde entrée de grille destinée à recevoir une tension de référence inférieure ($V_{REF-LOW}$) fixant une limite inférieure ($V_{LOW}$) de la plage de fonctionnement linéaire (LOR) ;
- un premier montage de miroir de courant (25a) connecté pour extraire de la sortie du transconducteur (28) un courant qui reproduit un premier courant interne circulant dans une branche de la paire différentielle de transistors P (24a) liée à la première entrée de grille de ladite paire différentielle de transistors P ;
- une paire différentielle de transistors N (24b) avec une autre première entrée de grille également connectée à l'entrée de tension du transconducteur, et une autre seconde entrée de grille destinée à recevoir une tension de référence supérieure ($V_{REF-HIGH}$) fixant une limite supérieure ($V_{HIGH}$) de la plage de fonctionnement linéaire (LOR) ; et
- un second montage de miroir de courant (25b) connecté pour fournir à la sortie du transconducteur (28) un courant qui reproduit un second courant interne circulant dans une branche de la paire différentielle de transistors N (24b) liée à ladite autre première entrée de grille de la paire différentielle de transistors N.

6. Module VCO (100) selon l'une quelconque des revendications précédentes, dans lequel un gain VCO ($K_{VCO\,1}$) du circuit VCO (1) associé à la première entrée de tension (11) est inférieur à un autre gain VCO ($K_{VCO\,2}$) dudit circuit VCO associé à la seconde entrée de tension (12), chaque gain VCO étant une dérivée de la fréquence (Fvco) du signal VCO par rapport à la valeur de la tension ($V_1$, $V_2$) transmise à la première ou seconde entrée de tension correspondante, pendant que la valeur transmise à l'autre desdites première et seconde entrées de tension est maintenue constante.

7. Dispositif à verrouillage de phase (PLL) comprenant :

- un module VCO (100) selon l'une quelconque des revendications précédentes ;
- un système de comparaison de phase (30) connecté pour recevoir une phase d'horloge de référence (REF_PHASE) et une phase obtenue à partir du signal VCO émis par le module VCO (100), et ledit système de comparaison de phase étant adapté pour produire un signal de comparaison représentatif d'une différence entre la phase d'horloge de référence et la phase obtenue à partir du signal VCO ;
- un filtre à boucle (31) connecté en série avec le système de comparaison de phase (30) et en aval de celui-ci de manière à recevoir en entrée le signal de comparaison, et adapté pour produire en sortie une tension correspondant au signal de comparaison filtré ; et
- un convertisseur de fréquence (32) adapté pour produire la phase obtenue à partir du signal VCO par division de fréquence ou augmentation de fréquence avec un facteur de division ou d'augmentation fixe ;

dans lequel une sortie du filtre à boucle (31) est connectée à la première entrée de tension (11) du circuit VCO (1), de sorte que le circuit VCO à partir de la première entrée de tension (11), le convertisseur de fréquence (32), le système de comparaison de phase (30) et le filtre à boucle (31) appartiennent à une première boucle de rétroaction dans le dispositif PLL, et aussi, que l'intégrateur (2), le circuit VCO à partir de la seconde entrée de tension (12), le convertisseur de fréquence (32), le système de comparaison de phase et le filtre à boucle appartiennent en outre à une seconde boucle de rétroaction dans ledit dispositif PLL.

**FIG. 1**

**FIG. 3a**

**FIG. 3b**

**FIG. 2**

**FIG. 4**

**FIG. 5a**

**FIG. 5b**

**EP 2 784 940 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2012074998 A1